# EUROPEAN PATENT SPECIFICATION

(11) **EP 1 114 448 B1**
(45) Date of publication and mention of the grant of the patent: **25.06.2008**
(21) Application number: 00927187.5
(22) Date of filing: 08.05.2000
(51) Int. Cl.: H01L 21/285, H01L 21/28, H01L 23/485

(54) **A METHOD OF MANUFACTURING A SEMICONDUCTOR DEVICE**
VERFAHREN ZUR HERSTELLUNG EINER HALBLEITERVORRICHTUNG
PROCEDE DE FABRICATION DE DISPOSITIFS A SEMI-CONDUCTEUR

(30) Priority: 27.05.1999 EP 99201693
(43) Date of publication of application: 11.07.2001
(73) Proprietor: NXP B.V., 5656 AG Eindhoven (NL)
(72) Inventor: DRUIJF, Klaas, G., NL-5656 AA Eindhoven (NL); DIEKEMA, Margriet, L., NL-5656 AA Eindhoven (NL)
(74) Representative: White, Andrew Gordon
(86) International application number: PCT/EP2000/004221
(87) International publication number: WO 2000/074126

(56) References cited:
- EP-A- 0 812 009
- US-A- 5 229 307
- US-A- 5 731 239
- US-A- 5 981 367

## Description

The invention relates to a method of manufacturing a semiconductor device, in particular an integrated circuit, in a superficial silicon layer of a wafer, which superficial silicon layer is provided at a surface with a component comprising an area of silicon, which area is at least substantially marked off by insulating material and covered with a high-resistivity phase of titanium silicide, whereupon the wafer is subjected to a phase-transformation anneal to transform the high-resistivity phase of titanium silicide into a low-resistivity phase of titanium silicide.

Titanium silicide has become the most widely applied silicide in the VLSI industry for self-aligned silicide applications, which aim at reducing sheet and contact resistances of circuits. In a typical application, titanium silicide (TiSi₂) exists as either an orthorhombic base-centered phase having 12 atoms per unit cell and a resistivity of about 60-100 µΩcm, which high-resistivity phase is also known as the C49 phase of titanium silicide, or as a more thermodynamically-favored orthorhombic phase having 24 atoms per unit cell and a resistivity of about 12-20 µΩcm, which low-resistivity phase is also known as the C54 phase of titanium silicide. When using generally accepted process conditions for forming titanium silicide, the less-desirable, high-resistivity (C49) phase of titanium silicide is formed first. In order to obtain the low-resistivity (C54) phase of titanium silicide, a high-temperature phase-transformation anneal is needed.

A method of manufacturing a semiconductor device of the kind mentioned in the opening paragraph is known from Japanese Patent Application JP-A-8-008211. In the known method, a surface of a monocrystalline silicon wafer is provided with a MOS transistor having a polycrystalline or amorphous silicon gate, a source and a drain, which elements each provide part of an exposed area of silicon, which area of silicon is at least substantially marked off by insulating material provided by oxide or nitride sidewall spacers and oxide field insulating regions (not shown in figures). The wafer is subsequently provided with a polycrystalline or amorphous silicon layer having a thickness in the order of 10 nm, which silicon layer is topped by a titanium layer having a thickness of 30 to 40 nm or more. In a next step, the wafer is subjected to a silicide-formation anneal in order to form the high-resistivity (C49) phase of titanium silicide at the entire surface of the wafer. The silicide formation anneal is carried out until the silicon layer above the insulating material as well as the titanium layer above the gate, the drain and the source is converted over its entire thickness. Parts of the titanium layer left behind at the surface of the wafer after the silicide formation anneal are removed by means of selective etching. After removal of the titanium layer parts, the wafer is subjected to the phase-transformation anneal, in order to transform the high-resistivity (C49) phase of titanium silicide into the low-resistivity (C54) phase of titanium silicide. The entire surface of the wafer is then etched back in order to remove the low-resistivity (C54) phase of titanium silicide present on the insulating material. During this etch-back process, also part of the low-resistivity (C54) phase of titanium silicide present on the gate, the source and the drain is removed.

In the above-mentioned Japanese Patent Application JP-A-8-008211, the entire surface of the wafer is provided with the high-resistivity (C49) phase of titanium silicide in order to make the subsequent transformation into the low-resistivity (C54) phase of titanium silicide independent of device line-width. It is thought that the C49 into C54 phase transformation of titanium silicide is becoming increasingly difficult as the device line-width continues to be scaled down.

A disadvantage of the known method is that ultimately the entire surface of the wafer is covered with the low-resistivity (C54) phase of titanium silicide. An etch-back operation is thus needed to re-expose the insulating material provided by the oxide or nitride sidewall spacers and the oxide field insulating regions. This etch-back operation represents an additional process step, which is rather critical. If the etch-back operation is stopped too early, titanium silicide remainders are left behind on e.g. the oxide or nitride sidewall spacers, which remainders may give rise to serious leakage currents due to a problem commonly referred to as over-spacer bridging. On the other hand, if the etch-back operation is carried on too long, the sheet and contact resistances of the MOS transistor are adversely affected.

EP 0 812 009 discloses a method of forming silicided narrow polysilicon lines. A prior gas implant makes the transformation from C49 to C54 easier. The transformation is performed by RTA.

It is an object of the invention to provide a method of manufacturing a semiconductor device of the kind mentioned in the opening paragraph, which enables transformation of the high-resistivity (C49) phase of titanium silicide into the low-resistivity

### (C54) phase of titanium silicide without the introduction of additional critical process steps.

According to the invention, this object is achieved in that the transformation of the high-resistivity phase of titanium silicide into the low-resistivity phase of titanium silicide is promoted by providing the area with an extension of silicon, which extension is at least substantially marked off by insulating material and covered with the high-resistivity phase of titanium silicide, the extension being relatively large compared to the area.

The invention is based *inter alia* on the insight, that the transformation of the high-resistivity (C49) phase of titanium silicide into the low-resistivity (C54) phase of titanium silicide is dependent on surface area rather than line-width. By providing an area of silicon covered with the C49 phase of titanium silicide with a relatively large extension of silicon covered by the C49 phase of titanium silicide, the probability that during the phase transformation anneal the C49 phase of titanium silicide present on the area of silicon is transformed into the C54 phase of titanium silicide increases.

Advantageous embodiments of the method in accordance with the invention are described in the dependent claims.

These and other aspects of the invention will be apparent from and elucidated with reference to the embodiments described hereinafter and shown in the drawing. In the drawing:
Fig. 1 shows a diagrammatic top view of a process control module manufactured using the method in accordance with the invention, which process control module contains a 4x4 array of floating gate transistors,
Fig. 2 shows a diagrammatic cross-sectional view of a floating gate transistor manufactured using the method in accordance with the invention, which cross-sectional view is taken along line A-A in Fig. 1,
Figs. 3 to 6 show in diagrammatic cross-sectional views successive stages in the manufacture of the floating gate transistor of Fig. 2 using the method in accordance with the invention,
Figs. 7 and 8 show cumulative graphs of the relationship between the phase transformation yield (Y in %) and the sheet resistance (R□in Ω/□) of, respectively, a polycrystalline silicon area covered with titanium silicide and a mono-crystalline silicon area covered with titanium silicide for different extension sizes.

Although the invention is illustrated hereinafter on the basis of a component in the form of a process control module, it will be evident to those skilled in the art that the invention may also be advantageously applied for a single active circuit device such as, for example, a field-effect transistor, a bipolar transistor or a floating gate transistor, or for a CMOS or BICMOS integrated circuit known per se.

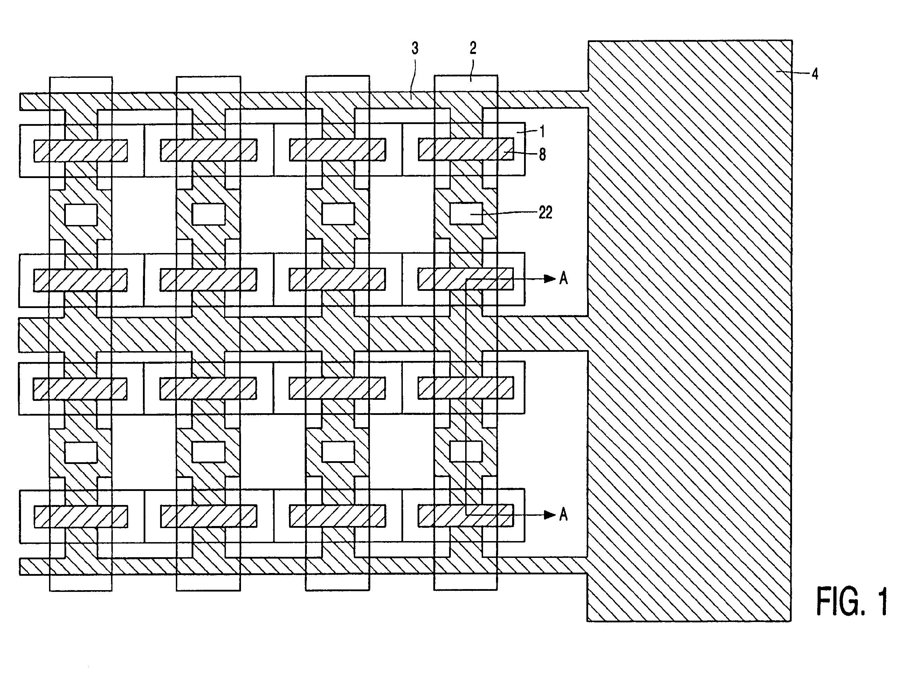

The process control module shown in a diagrammatic top view in Fig. 1 represents a memory containing storage cells, which are arranged in an array of 4 rows by 4 columns. It will be evident that the number of rows and columns in general is much larger than 4. The storage cells share electrical connections with all the other storage cells in their rows and columns and are situated at intersections of word lines 1 and bit lines 2. Each one of the storage cells comprises a field-effect transistor having a floating gate, a control gate, a source and a drain, which transistor is also referred to as floating gate transistor. The word lines 1 each provide for the control gates of the floating gate transistors situated in a common row and are driven by an address decoder (not shown). The bit lines 2 are each connected with the drains of the floating gate transistors situated in a common column and are connected with an address decoder and/or read circuit (not shown). The process control module also comprises source lines 3, which are grounded in the present example. Each of the source lines 3 connects the sources of the floating gate transistors with one another, which sources are situated in one or two adjacent common rows.

In the present example, the source lines 3 are provided with a common extension 4, which is relatively large compared to each of the source lines 3. The common extension 4 serves to promote the C49 into C54 phase transformation of titanium silicide on each of the source lines 3 during the self-aligned silicide process, also referred to as salicide process, to which the process control module is subjected during its manufacture. In the present example, the extension 4 is connected to all source lines 3 of the process control module. This is possible, because the source lines 3 are all grounded. It will be evident, however, that it is also possible to provide each of the source lines 3 with a separate extension 4, or to provide, for example, one or more of the word lines 1 with an extension.

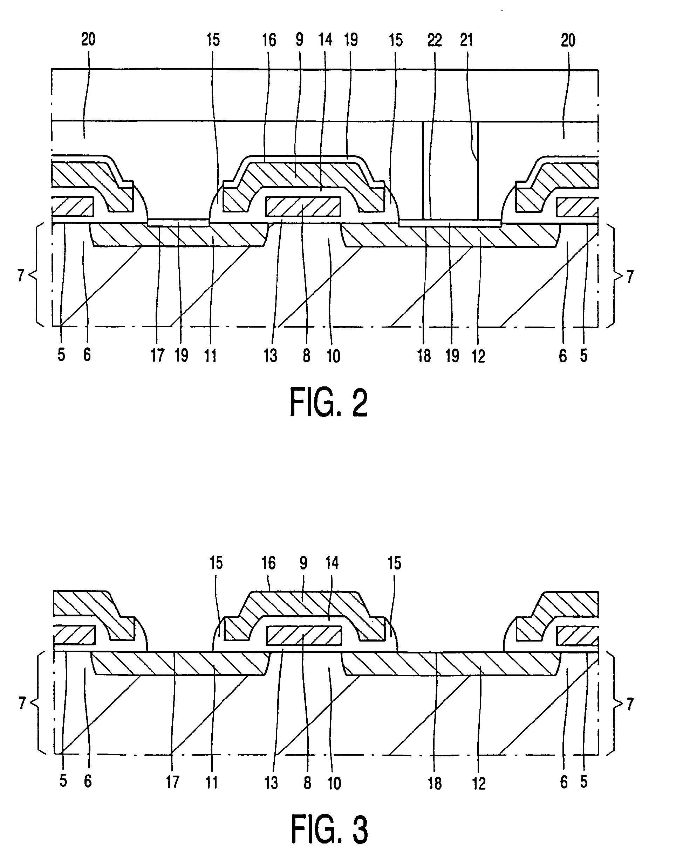

Fig. 2 shows a diagrammatic cross-sectional view of a floating gate transistor taken along line A-A in Fig. 1, similar elements being indicated by similar reference numerals. The floating gate transistor is disposed on a surface 5 of a superficial silicon layer 6 of a first conductivity type, in the present example the p-type, which superficial silicon layer 6 is part of a wafer 7, in the present example a mono-crystalline silicon wafer. The floating gate transistor has a floating gate 8 composed of, for example, n-type polycrystalline silicon, which is situated between an overlapping control gate 9 composed of, for example, n-type polycrystalline silicon and a channel 10, which is situated in the superficial silicon layer 6 and extends between a source 11 and a drain 12 of a second, opposite conductivity type, in the present example the n-type. The floating gate 8 is insulated from the superficial silicon layer 6 by a floating gate dielectric 13 and from the overlapping control gate 9 by an inter-gate dielectric 14. The control gate 9 is provided with sidewall spacers 15 composed of, for example, silicon oxide or silicon nitride. In order to reduce the sheet and contact resistances of the floating gate transistor, silicon regions 16, 17 and 18, which silicon regions are provided by respectively the control gate 9, the source 11 and the drain 12, are covered with a low-resistivity (C54) phase 19 of titanium silicide. The floating gate transistor is covered with a dielectric layer 20 composed of, for example, BPSG (boro-phospho-silicate glass) on top of TEOS (tetra-ethyl-ortho-silicate), which dielectric layer 20 is provided with a contact hole 21 to allow one of the bit lines 2 to contact the drain 12 of the floating gate transistor, thereby giving rise to a drain contact 22 (see also Fig. 1).

Figs. 3 to 6 show in diagrammatic cross-sectional views successive stages in the manufacture of the floating gate transistor of Fig. 2 the source 11 of which is connected with the extension 4 via one of the source lines 3 of the process control module.

The manufacture starts with the wafer 7 (Fig. 3), in the present example a monocrystalline silicon wafer, comprising the superficial silicon layer 6 of a first conductivity type, in the present example the p-type. The superficial silicon layer 6 is provided with the oxide field insulating regions (not shown) in a usual way by means of LOCOS (LOCal Oxidation of Silicon) or STI (Shallow Trench Isolation), which oxide field insulating regions are at least partly recessed in the superficial silicon layer 6 and define an active region therein. The surface 5 of the superficial silicon layer 6 is then provided with an insulating layer composed of, for example, silicon oxide, providing the floating gate dielectric 13. Alternatively, a dielectric material with a dielectric constant higher than that of silicon oxide, such as tantalum oxide, aluminium oxide or silicon nitride, may be applied. Then, a layer of, for example, polycrystalline silicon doped with, for example, phosphorus is applied, which layer is subsequently patterned in a usual photolithographic way to provide the floating gate 8. Instead of polycrystalline silicon, amorphous silicon or SiₓGe₁₋ₓ may be used, with x representing the fraction of silicon lying in the range between about 0.6 and 1. Then, the source 11 and the drain 12 of the second, opposite conductivity type, in the present example the n-type, are formed on opposite sides of the floating gate 8 by means of a self-aligned implantation of a dose of, for example, phosphorus or arsenic. In a next step, the floating gate 8 is covered with a further insulating layer composed of, for example, silicon oxide, providing the inter-gate dielectric 14. Alternatively, silicon oxynitride (SiON), a sandwich of silicon oxide and silicon nitride (ONO), or a dielectric material with a dielectric constant significantly higher than that of silicon oxide such as tantalum oxide, aluminum oxide or silicon nitride may be applied. Then, a layer of, for example, polycrystalline silicon doped with, for example, phosphorus is applied, which layer is subsequently patterned in a usual photolithographic way to provide the overlapping control gate 9. Instead of polycrystalline silicon, amorphous silicon or SiₓGe₁₋ₓ may be used, with x representing the fraction of silicon lying in the range between about 0.6 and 1. The sidewalls of the control gate 9 are subsequently provided with sidewall spacers 15 in a known way, for example, by means of deposition and anisotropic etch-back of a silicon oxide or a silicon nitride layer. The resulting situation is shown in Fig. 3.

The floating gate transistor comprises exposed silicon regions 16, 17 and 18, which exposed silicon regions are provided by, respectively, the control gate 9, the source 11 and the drain 12. Each of the exposed silicon regions 16, 17 and 18 is part of an exposed area of silicon, which exposed area of silicon is at least substantially marked off by insulating material. The exposed silicon region 16 is part of one of the word lines 1 (see Fig. 1). The word lines 1 each represent an exposed area of silicon, in the present example of polycrystalline silicon, which exposed area of silicon is at least substantially marked off by the insulating material provided by the nitride or oxide sidewall spacers 15 of the floating gate transistors situated in a common row and by oxide field insulating regions (not shown). The exposed silicon region 18 represents on its own (see Fig. 1) an exposed area of silicon, in the present example of mono-crystalline silicon, on its own, which exposed area of silicon is at least substantially marked off by the insulating material provided by the nitride or oxide sidewall spacers 15 of the floating gate transistors situated in two adjacent common rows and by oxide field insulating regions (not shown). Moreover, the exposed silicon region 17 is part of one of the source lines 3 (see Fig. 1). The source lines 3 each represent an exposed area of silicon, in the present example monocrystalline silicon, which exposed area of silicon is at least substantially marked off by the insulating material provided by the nitride or oxide sidewall spacers 15 of the floating gate transistors situated in one or two adjacent common rows and by oxide field insulating regions (not shown), and is provided with the common extension 4 of silicon, in the present example monocrystalline silicon. The common extension 4, which is at least substantially marked off by the insulating material provided by oxide field insulating regions (not shown), is applied in order to promote the C49 into C54 phase transformation of titanium silicide on each of the source lines 3 and is relatively large compared to each of the source lines 3.

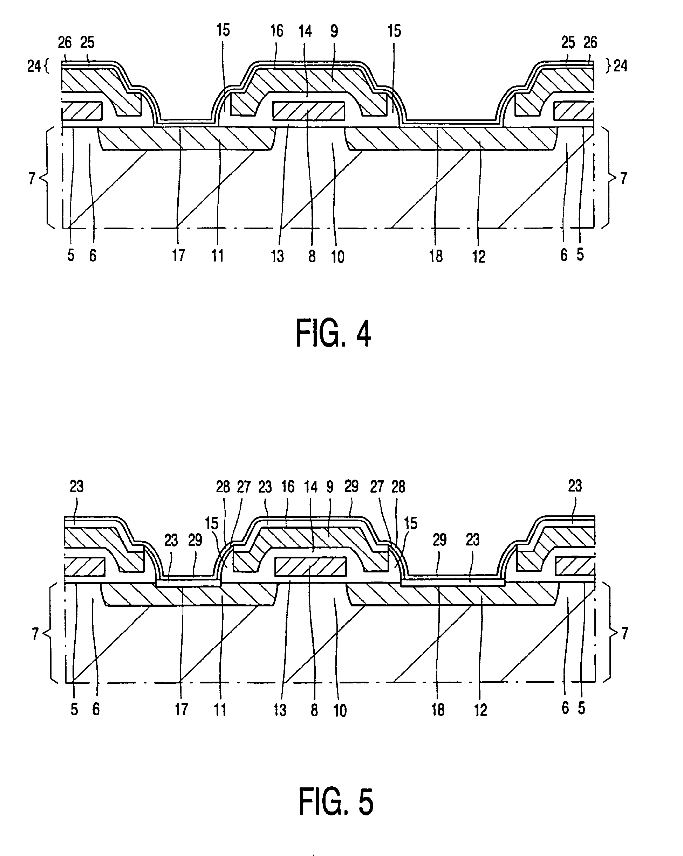

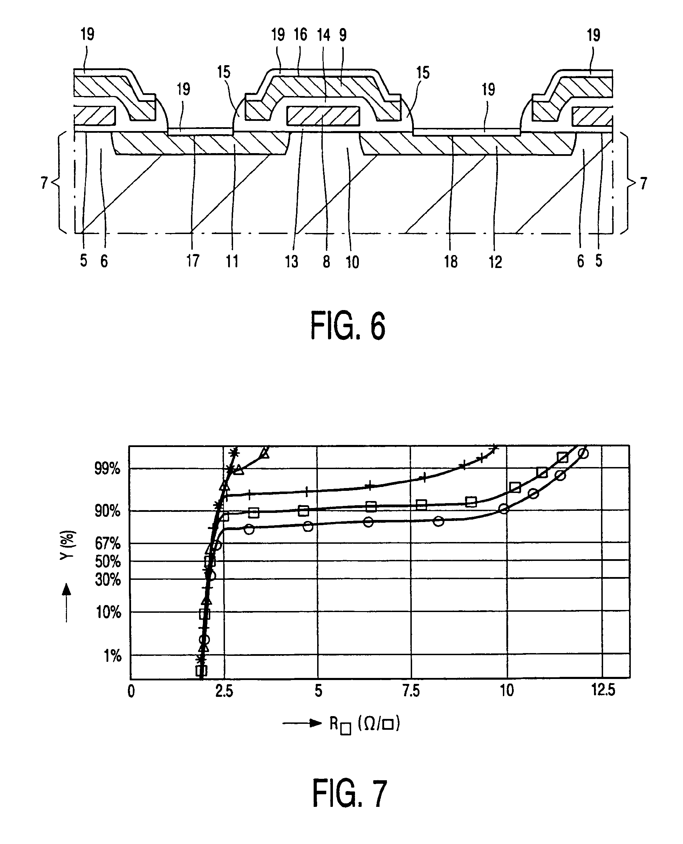

In order to reduce the sheet and contact resistances of the process control module of Fig. 1, the wafer 7 is now subjected to a self-aligned silicide process, also referred to as salicide process, in which process each exposed area of silicon and, hence, each of the exposed silicon regions 16, 17 and 18 is provided with a high-resistivity (C49) phase 23 of titanium silicide (see Fig. 5), which high-resistivity phase 23 needs to be transformed into the low-resistivity (C54) phase 19 of titanium silicide at a later stage in the same process (see Fig. 6). The successive stages of this salicide process will now be described in more detail with respect to the exposed silicon regions 16, 17 and 18 of the floating gate transistor. It will be evident, however, that each exposed area of silicon of the process control module of Fig. 1 and, hence, each of the source lines 3, which are provided with the extension 4 for the above-mentioned reason, passes through the same succession of stages.

The salicide process usually starts with a deoxidation step to remove oxide remainders from the exposed silicon regions 16, 17 and 18 (Fig. 3). These oxide remainders may have been formed as a result of exposure to air (native oxide) or as a result of masked etching of a layer composed of, for example, TEOS (tetra-ethyl-ortho-silicate), which can be used to protect certain silicon regions against silicidation during the above mentioned salicide process. Removal of these oxide remainders may be carried out by means of wet chemical etching using, for example, a solution containing 1% hydrofluoric acid (HF).

In a next step (Fig. 4), a titanium-containing layer 24 is applied to the wafer 7. The titanium-containing layer 24 may be applied as a single layer of titanium by means of plasma-enhanced chemical vapor deposition (PECVD) at a temperature between about 400°C and 700°C, whereby the exposed silicon regions 16, 17 and 18 are immediately provided with the high-resistivity (C49) phase of titanium silicide, or by means of physical vapor deposition at a relatively low temperature, whereby the exposed silicon regions 16, 17 and 18 are provided with titanium, which is to be converted into the high-resistivity (C49) phase of titanium silicide at a later stage in the process, as described below. However, the titanium-containing layer 24 is advantageously applied as a double-layer consisting of a first sub-layer 25 of titanium with a second sub-layer 26 of titanium nitride on top, which second sub-layer 26 acts as a capping layer to avoid e.g. adverse oxidation of the first sub-layer 25 of titanium. The first sub-layer 25 and the second sub-layer 26 may be applied by means of physical vapor deposition in a thickness of, for example, about 30 nm and about 25 nm, respectively.

In a next step (Fig. 5), the wafer 7 is subjected to a silicide formation anneal in order to convert the first sub-layer 25 of titanium, at the silicon regions 16, 17 and 18, to the high-resistivity (C49) phase 23 of titanium silicide over at least part of its thickness. Whether the first sub-layer 25 of titanium is converted to the high-resistivity phase 23 of titanium silicide over part of its thickness or over its complete thickness, depends on whether the silicide formation anneal is carried out in nitrogen (N₂) or a nitrogen-based atmosphere, or in an inert-gas atmosphere of, for example, argon (Ar). In the former case, the first sub-layer 25 of titanium will react with nitrogen from the atmosphere over part of its thickness to form titanium nitride. Although the silicide formation anneal may be carried out as a conventional furnace anneal, it is advantageously carried out as a rapid thermal anneal (RTA) in order to lower the thermal budget of the wafer 7. A lower thermal budget at this stage of the salicide process is favorable, because it counteracts the occurrence of parasitic effects such as, for example, lateral growth of titanium silicide over the sidewall spacers 15, which is a problem known as over-spacer bridging. The rapid thermal anneal may be carried out in, for example, nitrogen (N₂) at a temperature of, for example, about 730°C during a time of, for example, about 20 seconds.

During the silicide formation anneal the high-resistivity phase 23 of titanium silicide is formed on top of each area of silicon, which area is at least substantially marked off by the insulating material provided by the oxide or nitride sidewall spacers 15 and the oxide field insulating regions (not shown), and, hence, on top of each of the source lines 3 and the extension 4 with which each of the source lines 3 is connected. On top of the insulating material provided by the oxide or nitride sidewall spacers 15 and the oxide field insulating regions (not shown) titanium silicide is not formed.

After finishing the silicide formation anneal, titanium-containing material not converted into the high-resistivity phase 23 of titanium silicide needs to be removed, which titanium-containing material comprises titanium 27 and titanium nitride 28, present on the insulating material provided by the oxide or nitride sidewall spacers and the oxide field insulating regions, and titanium nitride 29 present on the high-resistivity phase 23 of titanium silicide. The titanium 27 present on the insulating material may comprise small amounts of oxygen and silicon if silicon oxide is applied as an insulating material or small amounts of oxygen, nitrogen and silicon if silicon nitride is applied as an insulating material. The titanium 27 and the titanium nitride 28,29 may be removed after phase transformation of the high-resistivity phase 23 of titanium silicide into the low-resistivity phase 19 of titanium silicide, but are preferably removed before said phase transformation. This can be done by means of selective wet etching using, for example, a so-called standard clean 1 (SC1) chemistry at, for example, about 30°C during a time of, for example, about 20 minutes, which SC1 chemistry involves a mixture of ammonium hydroxide (NH₄OH): hydrogen peroxide (H₂O₂): water (H₂O) in a ratio of, for example, about 1:2:7. After this etch treatment, the wafer 7 is subjected to a phase transformation anneal in order to transform the high-resistivity (C49) phase 23 at the silicon regions 16, 17 and 18 into the low-resistivity (C54) phase 19 of titanium silicide (Fig. 6). Although the phase transformation anneal may be carried out as a conventional furnace anneal, it is advantageously carried out as a rapid thermal anneal (RTA) in order to lower the thermal budget of the wafer 7. A lower thermal budget at this stage of the salicide process is favorable, because it counteracts the occurrence of parasitic effects such as, for example, dopant redistribution between doped areas of silicon and the titanium silicide with which these areas are in contact. The rapid thermal anneal may be carried out in, for example, nitrogen (N₂) at a temperature of, for example, about 900°C during a time of, for example, about 20 seconds.

During the phase transformation anneal, the high-resistivity (C49) phase 23 of titanium silicide is transformed into the low-resistivity (C54) phase 19 of titanium silicide at each area of silicon, which area is at least substantially marked off by the insulating material provided by the oxide or nitride sidewall spacers 15 and the oxide field insulating regions (not shown). In order to promote the above-described C49 into C54 phase transformation on each of the source lines 3, the source lines 3 are provided with a relatively large extension 4, which is covered with the high-resistivity (C49) phase of titanium silicide as well.

Finally, the dielectric layer 20 composed of, for example, BPSG (boro-phospho-silicate glass) on top of TEOS (tetra-ethyl-ortho-silicate), is applied to the wafer 7, which dielectric layer 20 is provided with the contact hole 21 to allow one of the bit lines 2 to contact the drain 12 of the floating gate transistor, thereby giving rise to the drain contact 22, the result of which is shown in Fig. 2.

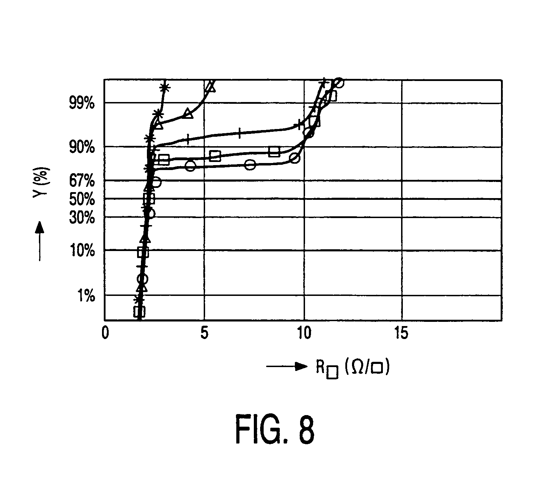

Figs. 7 and 8 show cumulative graphs of the relationship between the phase transformation yield (Y in %) and the sheet resistance (R_{□} in Ω/□) of, respectively, a doped polycrystalline silicon area covered with titanium silicide and a doped mono-crystalline silicon area covered with titanium silicide for different extension sizes.

The polycrystalline silicon area is doped at a concentration of about 4.10¹⁵ atoms/cm² and has a surface area of about 30 x 0.35 = 10.5 µm². The monocrystalline silicon area is also doped at a concentration of about 4.10¹⁵ atoms/cm² and has a surface area of about 30 x 0.40 = 12.0 µm². The sizes of the extensions are about 18 µm² (circles), 32 µm² (squares), 50 µm² (crosses), 110 µm² (triangles) and 450 µm² (stars) in both graphs. The titanium silicide is present in a thickness of about 30 nm on each of the doped areas and the extension connected therewith, which thickness is approximately independent of the phase in which the titanium silicide is. For each combination of silicon area and extension size, a total of 400 samples have been tested. Hence, a phase-transformation yield (Y) of 10% corresponds to 40 samples, a yield of 50% to 200 samples, a yield of 90% to 360 samples, and so on.

Furthermore, it is to be noted that the highest sheet resistances depicted (about 10-12.5 Ω/□) correspond to the high-resistivity (C49) phase of titanium silicide, whereas the lowest sheet resistances depicted (about 2 Ω/□) correspond to the low-resistivity (C54) phase of titanium silicide. The variation in the sheet resistances corresponding to the high-resistivity (C49) phase of titanium silicide can probably be attributed to small deviations in the stoichiometry of the high-resistivity phase.

The results presented in Figs. 7 and 8 clearly reveal that the phase-transformation yield (Y) at a given sheet resistance (R_{□}) increases with increasing extension size. From the design point of view, a sheet resistance of about 5 Ω/□ is generally considered sufficiently low. Figs. 7 and 8 show that, in order to reach a phase transformation yield (Y) of about 95% at a sheet resistance of 5 Ω/□, the doped polycrystalline silicon area of 10.5 µm² as well as the doped mono-crystalline silicon area of 12.0 µm² should be provided with an extension having a size of about 50 µm². In order to reach a phase transformation yield (Y) of about 99% at the same sheet resistance of 5 Ω/□, the extension size should be about 110 µm² for the doped polycrystalline silicon area of 10.5 µm² as well as for the doped monocrystalline silicon area of 12.0 µm².

It will be apparent that the invention is not limited to the embodiments described above, but that many variations are possible to those skilled in the art within the scope of the invention. The area of silicon, which is provided with an extension to promote the C49 into C54 phase transformation of titanium silicide, may comprise, for example, monocrystalline silicon, polycrystalline silicon, amorphous silicon or silicon germanium alloy, namely SiₓGe₁₋ₓ, with x, being the fraction of silicon, lying in the range between about 0.6 and 1. Because this alloy largely consists of silicon, it is regarded as silicon herein. Moreover, the silicon may be intrinsic or intentionally doped to exhibit p-type or n-type conductivity. In the embodiments described above, the extension was provided in a rectangular form. It will be apparent however that the planar geometry of the extension is irrelevant, provided its surface area is sufficiently large to reach the above-mentioned phase transformation. Furthermore, in the embodiments described above the wafer is a mono-crystalline wafer having a superficial silicon layer defined at a main surface of it. Alternatively, the wafer may be a silicon-on-insulator (SOI) wafer comprising a body of semiconductor material, for example silicon, which body is provided at a main surface with a layer of insulating material, for example silicon oxide or silicon nitride, which layer of insulating material is covered with a layer of silicon representing the above-mentioned superficial silicon layer.

## Claims

1. A method of manufacturing a semiconductor device, in particular an integrated circuit, in a superficial silicon layer (6) of a wafer (5), which superficial silicon layer (6) is provided at a surface (5) with a component comprising an area of silicon (16,17,18), which area is marked off by insulating material (15) and covered with a high-resistivity phase of titanium silicide (19), whereupon the wafer is subjected to a phase transformation anneal to transform the high-resistivity phase of titanium silicide into a low-resistivity phase of titanium silicide, **characterized in that** the transformation of the high-resistivity phase of titanium silicide into the low-resistivity phase of titanium silicide is promoted by providing the area (4) with an extension area of silicon, which extension area is marked off by insulating material and covered with the high-resistivity phase of titanium silicide, the extension area being relatively large compared to the area.

2. A method as claimed in claim 1, **characterized in that** the high-resistivity phase of titanium silicide covering the area and the extension area of silicon is formed by applying a titanium-containing layer to the wafer, subjecting the wafer to a silicide formation anneal to convert the titanium-containing layer at the area and the extension to the high-resistivity phase of titanium silicide over at least part of its thickness.

3. A method as claimed in claim 2, **characterized in that** the titanium-containing layer is applied as a double-layer with a first sub-layer comprising titanium with on top a second sub-layer comprising titanium nitride.

4. A method as claimed in claim 2 or 3, **characterized in that** in between the silicide formation anneal and the phase transformation anneal, the wafer is subjected to an etch treatment to remove all titanium-containing material which is not converted to the high-resistivity phase of titanium silicide from the insulating material and from the area and the extension area.

5. A method as claimed in any one of claims 2 through 4, **characterized in that** the silicide formation anneal is carried out as a rapid thermal anneal.

6. A method as claimed in any one of the preceding claims, **characterized in that** the phase transformation anneal is carried out as a rapid thermal anneal.

7. A method as claimed in any one of the preceding claims, **characterized in that** the component is applied to the surface of the superficial silicon layer as a process control module.

8. A method as claimed in any one of claims 1 through 6, **characterized in that** the component is applied to the surface of the superficial silicon layer (6) as a transistor having a gate (9), a source (11) and a drain (12), wherein the area of silicon (6) is provided by at least one element of the gate (9), the source (11) and the drain (12).

## Patentansprüche

1. Verfahren zur Herstellung einer Halbleitervorrichtung, insbesondere einer integrierten Schaltung, in einer Silizium-Oberflächenschicht (6) eines Wafers (5), die an einer Oberfläche (5) mit einem Bauelement umfassend ein Gebiet aus Silizium (16, 17, 18) versehen ist, das durch isolierendes Material (15) abgegrenzt ist und mit einer hochohmigen Phase des Titansilizids (19) abgedeckt ist, woraufhin der Wafer einer Phasentransformations-Wärmebehandlung unterzogen wird, um die hochohmige Phase des Titansilizids in eine niederohmige Phase des Titansilizids zu transformieren, **dadurch gekennzeichnet, dass** die Transformation der hochohmigen Phase des Titansilizids in die niederohmige Phase des Titansilizids durch Versehen des Gebiets (4) mit einem Erweiterungsgebiet aus Silizium gefördert wird, wobei das Erweiterungsgebiet durch isolierendes Material abgegrenzt wird und mit der hochohmigen Phase des Titansilizids abgedeckt wird, und wobei das Erweiterungsgebiet relativ groß im Vergleich mit dem Gebiet ist.

2. Verfahren nach Anspruch 1, **dadurch gekennzeichnet, dass** die hochohmige Phase des Titansilizids, die das Gebiet und das Erweiterungsgebiet aus Silizium abdeckt, durch Aufbringen einer Titan enthaltenden Schicht, Unterwerfen des Wafers unter eine Silizidbildungs-Wärmebehandlung zur Umwandlung der Titan enthaltenden Schicht im Gebiet und im Erweiterungsgebiet in die hochohmige Phase des Titansilizids über mindestens einen Teil ihrer Dicke gebildet wird.

3. Verfahren nach Anspruch 2, **dadurch gekennzeichnet, dass** die Titan enthaltende Schicht als Doppelschicht mit einer ersten Sub-Schicht enthaltend Titan und einer darüber liegenden zweiten Sub-Schicht enthaltend Titannitrid abgeschieden wird.

4. Verfahren nach Anspruch 2 oder 3, **dadurch gekennzeichnet, dass** zwischen der Silizidbildungs-Wärmebehandlung und der Phasentransformations-Wärmebehandlung der Wafer einer Ätzbehandlung unterzogen wird, um jegliches Titan enthaltendes Material, das nicht in die hochohmige Phase von Titansilizid umgewandelt ist, vom isolierenden Material und vom Gebiet und dem Erweiterungsgebiet zu entfernen.

5. Verfahren nach einem der Ansprüche 2 bis 4, **dadurch gekennzeichnet, dass** die Silizidbildungs-Wärmebehandlung als schnelle thermische Wärmebehandlung ausgeführt wird.

6. Verfahren nach einem der vorstehenden Ansprüche, **dadurch gekennzeichnet, dass** die Phasentransformations-Wärmebehandlung als schnelle thermische Wärmebehandlung ausgeführt wird.

7. Verfahren nach einem der vorstehenden Ansprüche, **dadurch gekennzeichnet, dass** das Bauelement als ein Prozesssteuerungsmodul auf die Oberfläche der Oberflächensiliziumschicht aufgebracht wird.

8. Verfahren nach einem der Ansprüche 1 bis 6, **dadurch gekennzeichnet, dass** das Bauelement als ein Transistor mit Gate (9), Source (11) und Drain (12) auf die Oberfläche der Oberflächen-Siliziumschicht aufgebracht wird, wobei das Gebiet aus Silizium (6) durch mindestens eines der Elemente Gate (9), Source (11) und Drain (12) gebildet wird.

## Revendications

1. Procédé de fabrication d'un dispositif à semiconducteur, en particulier d'un circuit intégré, dans une couche de silicium superficielle (6) d'une plaquette (5), laquelle couche de silicium superficielle (6) est dotée au niveau d'une surface (5) d'un composant comportant une zone de silicium (16, 17, 18) laquelle zone est délimitée par un matériau isolant (15) et recouverte d'une phase de siliciure de titane présentant une résistivité élevée (19) sur laquelle la plaquette est soumise à un recuit de transformation de phase en vue de transformer la phase à résistivité élevée de siliciure de titane en une phase à basse résistivité de siliciure de titane,
**caractérisé en ce que** la transformation de la phase à haute résistivité de siliciure de titane en phase à basse résistivité de siliciure de titane est favorisée en fournissant à la zone (4) une zone d'extension de silicium, zone d'extension qui est délimitée par un matériau isolant et recouverte de la phase à haute résistivité de siliciure de titane, la zone d'extension étant relativement grande en comparaison avec la zone.

2. Procédé selon la revendication 1, **caractérisé en ce que** la phase à résistivité élevée de siliciure de titane recouvrant la zone et la zone d'extension de silicium est formée en appliquant une couche contenant du titane sur la plaquette, en soumettant la plaquette à un recuit de formation de siliciure en vue de transformer la couche contenant du titane au niveau de la zone et de l'extension en phase à résistivité élevée de siliciure de titane sur au moins une partie de son épaisseur.

3. Procédé selon la revendication 2, **caractérisé en ce que** la couche contenant du titane est appliquée sous forme d'une double couche avec une première sous-couche contenant du titane comportant sur le dessus une seconde sous-couche constituée de nitrure de titane.

4. Procédé selon la revendication 2 ou 3, **caractérisé en ce que**, entre le recuit de formation de siliciure et le recuit de transformation de phase, la plaquette est soumise à un traitement de gravure afin d'éliminer tout le matériau contenant du titane qui n'est pas transformé en phase à résistivité élevée de siliciure de titane à partir du matériau isolant et à partir de la zone et de la zone d'extension.

5. Procédé selon l'une quelconque des revendications 2 à 4, **caractérisé en ce que** le recuit de formation de siliciure est effectué sous la forme d'un recuit thermique rapide.

6. Procédé selon l'une quelconque des revendications précédentes **caractérisé en ce que** le recuit de transformation de phase est effectué sous la forme d'un recuit thermique rapide.

7. Procédé selon l'une quelconque des revendications précédentes, **caractérisé en ce que** le composant est appliqué à la surface de la couche de silicium superficielle en tant que module de contrôle de traitement.

8. Procédé selon l'une quelconque des revendications 1 à 6, **caractérisé en ce que** le composant est appliqué à la surface de la couche de silicium superficielle (6) sous la forme d'un transistor comportant une grille (9), une source (11) et un drain (12), dans lequel la zone de silicium (6) est fournie par au moins un élément de la grille (9), de la source (11) et du drain (12).
